# EUROPEAN PATENT APPLICATION

(11) **EP 4 583 160 A1**
(43) Date of publication of application: **09.07.2025**
(21) Application number: 23867052.5
(22) Date of filing: 28.06.2023
(51) Int. Cl.: H01L 23/498

(54) **CHIP AND PREPARATION METHOD THEREFOR, AND ELECTRONIC DEVICE**

(30) Priority: 22.09.2022 CN 202211158528
(71) Applicant: Huawei Technologies Co., Ltd., Shenzhen, Guangdong 518129 (CN)
(72) Inventor: LI, Heng, Shenzhen, Guangdong 518129 (CN); DONG, Jinwen, Shenzhen, Guangdong 518129 (CN)
(74) Representative: Goddar, Heinz J.
(86) International application number: PCT/CN2023/103508
(87) International publication number: WO 2024/060757

(57) **Abstract**

Embodiments of this application provide a chip and a preparation method thereof, and an electronic device, to resolve a technical problem that electrical performance of a metal pillar formed in a via is poor due to an undercut of a mask structure during TSV etching. The chip includes a substrate, a stack structure, a mask structure, a first dielectric layer, an insulation layer, and a conductive layer. The stack structure and the mask structure are sequentially stacked on the stack structure. The chip includes a first via segment that penetrates the mask structure and the stack structure and a second via segment that penetrates the substrate. The first dielectric layer covers a side wall of the first via segment. The first dielectric layer can protect the mask structure from being etched, to avoid an undercut on the side wall of the first via segment. The conductive layer is formed in filling space enclosed by the insulation layer. In this way, a structure of the insulation layer does not have a disadvantage like a hole when being affected by a damage or a disadvantage on an inner wall surface of the first via segment, so that structural continuity of the conductive layer can be implemented, to ensure electrical performance of the chip.

## Description

This application claims priority to Chinese Patent Application No. 202211158528.2, filed with the China National Intellectual Property Administration on September 22, 2022 and entitled "CHIP AND PREPARATION METHOD THEREOF, AND ELECTRONIC DEVICE", which is incorporated herein by reference in its entirety.

### TECHNICAL FIELD

This application relates to the field of semiconductors, and in particular, to a chip and a preparation method thereof, and an electronic device.

### BACKGROUND

Through silicon via (through silicon via, TSV) etching is as follows: First, a mask is illuminated by using an exposure light source, so that a preset pattern on the mask is copied onto a photoresist, and then the pattern on the photoresist is re-etched to another structure through etching. For example, the pattern on the photoresist may be re-etched onto a hard mask (hard mask, HM), and then the pattern is etched and transferred onto a substrate through the hard mask, to form a via inside a chip.

When the hard mask is of a multi-layer structure, in the process of generating the via through TSV etching, because materials of a plurality of film layers between the substrate and the hard mask are different, some film layers have a high etching speed, and some film layers have a low etching speed. For example, compared with an oxide layer, a low-k (low-k) dielectric layer has a higher etching speed. A film layer with a high etching speed and a film layer with a low etching speed form a hole on a side wall of the via. This phenomenon is referred to as an undercut.

When another film layer like an insulation layer continues to be stacked on the undercut side wall of the via, for example, when a silicon oxide film layer is deposited, a part of the silicon oxide film layer grows on the side wall of the via, and a part of the silicon oxide film layer grows in the hole. Consequently, the film layers are discontinuous. In this case, when a metal pillar is formed through electroplating, metal cannot be electroplated at locations at which the film layers are discontinuous, because the locations cannot be powered on. Consequently, a structure of the metal pillar is discontinuous, and electrical performance of the chip is affected.

### SUMMARY

Embodiments of this application provide a chip and a preparation method thereof, and an electronic device, to resolve a technical problem that electrical performance of a chip is poor because a structure of a metal pillar formed in a via is discontinuous due to an undercut of a mask structure during TSV etching.

To achieve the foregoing objectives, the following technical solutions are used in embodiments of this application.

According to a first aspect, a chip is provided. The chip includes: a substrate, a stack structure, a mask structure, a first dielectric layer, an insulation layer, and a conductive layer. The stack structure is stacked on the substrate. The mask structure is stacked on the stack structure. A via extending in a direction perpendicular to the substrate is provided on a surface that is of the mask structure and that is away from the substrate, and the via penetrates the mask structure, the stack structure, and the substrate. The via includes a first via segment that penetrates the mask structure and the stack structure and a second via segment that penetrates the substrate. The first dielectric layer covers a side wall of the first via segment. The insulation layer covers the first dielectric layer and a side wall of the second via segment, and encloses filling space in the via. The conductive layer is formed in the filling space.

Based on the foregoing structural descriptions of the chip provided in this embodiment of this application, it can be learned that, in the chip, in comparison with that the second via segment directly covers the insulation layer, the first dielectric layer is formed between the first via segment and the insulation layer. When transverse etching occurs, the first dielectric layer is first etched, to protect a part that is of the stack structure and that is located in the first via segment from being etched, and avoid forming an undercut on the side wall of the first via segment. In addition, a structure of the insulation layer is not affected by a damage or a disadvantage on an inner wall surface of the first via segment, and there is no hole or other disadvantage that causes discontinuity of the insulation layer on the insulation layer. Therefore, structural continuity of the conductive layer can be implemented, to ensure electrical performance of the chip.

In an implementation of the first aspect, the substrate has a higher etching selection ratio relative to the first dielectric layer.

In this way, when the second via segment is formed, the first dielectric layer is less etched, and the stack structure is not undercut, to ensure that the conductive layer is of a continuous structure, so as to ensure electrical performance of the chip.

In an implementation of the first aspect, an edge of the first dielectric layer coincides with an edge of the second via segment at a location at which the first dielectric layer is connected to the second via segment.

In this way, it is ensured that a side wall surface of the first via segment is always covered with the first dielectric layer, to protect the stack structure. In addition, in comparison with that a radial size of a via enclosed by the first dielectric layer is greater than a radial size of the second via segment, in this embodiment of this application, the edge of the first dielectric layer coinciding with the edge of the second via segment can ensure that a size of the insulation layer does not suddenly change at the location at which the first dielectric layer is connected to the second via segment. In this way, a size of the conductive layer does not suddenly change, and this helps ensure electrical performance of the chip.

In an implementation of the first aspect, the conductive layer has a first surface and a second surface that are parallel to the substrate. The first surface is a surface away from the substrate, and the second surface is a surface away from the mask structure; the first surface and the surface that is of the mask structure and that is away from the substrate are on a same plane; and the second surface and a surface that is of the substrate and that is away from the mask structure are on a same plane.

In this way, the conductive layer can be connected to a device disposed on a side that is of the substrate and that is away from the mask structure, and can also be connected to a device disposed on a side that is of the mask structure and that is away from the substrate, so that the conductive layer is electrically connected to a plurality of devices. In an implementation of the first aspect, the first dielectric layer is of a multi-layer structure, and a plurality of layers in the multi-layer structure are sequentially stacked on the side wall of the first via segment in a radial direction of the via.

The first dielectric layer is of a multi-layer structure, so that reliability of a protection layer is further improved.

In an implementation of the first aspect, a material of the first dielectric layer includes at least one of silicon carbonitride, silicon oxynitride, silicon oxide, silicon nitride, silicon oxycarbonitride, silicon carbide, or silicon oxycarbide.

In an implementation of the first aspect, the chip further includes a diffusion barrier layer, an adhesion layer, and a seed layer. The insulation layer is covered with the diffusion barrier layer, the diffusion barrier layer is covered with the adhesion layer, the adhesion layer is covered with the seed layer, and the seed layer is located between the insulation layer and the conductive layer.

In this way, the diffusion barrier layer, the adhesion layer, and the seed layer are added, so that the conductive layer with a continuous structure is more easily formed.

In an implementation of the first aspect, the stack structure is a multi-layer structure, and a plurality of layers in the multi-layer structure are sequentially stacked on the substrate.

In an implementation of the first aspect, the stack structure includes: a first oxide layer, a silicon nitride layer, a second oxide layer, a dielectric material layer, and a third oxide layer that are sequentially stacked on the substrate.

In an implementation of the first aspect, the chip further includes a metal layer. The metal layer is disposed on the surface that is of the mask structure and that is away from the substrate and/or the surface that is of the substrate and that is away from the mask structure; and the conductive layer is electrically connected to the metal layer.

The conductive layer is electrically connected to the device (or chip) through the metal layer, so that reliability of the electrical connection between the conductive layer and the device (or chip) is ensured.

In an implementation of the first aspect, the chip further includes a solder ball. The solder ball is disposed on the surface that is of the mask structure and that is away from the substrate and/or the surface that is of the substrate and that is away from the mask structure, and is in contact with a surface of the conductive layer, and the solder ball is electrically connected to the conductive layer.

In an implementation of the first aspect, a material of the substrate includes at least one of monocrystalline silicon, monocrystalline germanium, gallium arsenide, indium phosphide, an III-V compound semiconductor material, an II-VI compound semiconductor material, glass, plastic, or a sapphire wafer.

In an implementation of the first aspect, the mask structure includes a titanium nitride layer, a silicon nitride layer, an aluminum oxide layer, or a silicon dioxide layer.

According to a second aspect, a chip preparation method is provided. The preparation method includes: forming a stack structure on a substrate; forming a mask structure on the stack structure; providing, on a surface that is of the mask structure and that is away from the substrate, a first via segment that penetrates the mask structure and the stack structure in a direction perpendicular to the substrate; forming a first dielectric layer on a side wall of the first via segment, so that the first dielectric layer covers the side wall of the first via segment; providing, on a bottom surface of the first via segment for which the first dielectric layer is formed on the side wall, a second via segment that penetrates the substrate in the direction perpendicular to the substrate, to provide, on the mask structure, a via that includes the first via segment and the second via segment and that extends in the direction perpendicular to the substrate; forming an insulation layer on the first dielectric layer and a side wall of the second via segment, so that the insulation layer covers the first dielectric layer and the second via segment, and encloses filling space in the via; and forming a conductive layer in the filling space.

Based on the foregoing descriptions of the chip preparation method provided in this embodiment of this application, it can be learned that in the preparation method, after the first via segment is formed and before the second via segment is formed, the first dielectric layer needs to be formed on the side wall of the first via segment. In this way, when the second via segment is formed, the first dielectric layer can protect the stack structure, and the mask structure is not transversely etched, to avoid forming an undercut on the side wall of the first via segment. In this way, when the insulation layer is formed on the first dielectric layer and the second via segment, because no undercut is formed on the side wall of the first via segment, there is no hole or other disadvantage that causes discontinuity of the insulation layer on the insulation layer. When the conductive layer is formed on the insulation layer, structural continuity of the conductive layer can be implemented, to ensure electrical performance of the chip.

In addition, the preparation method provided in this embodiment of this application does not affect a process flow before forming of the via and a process flow after forming of the via, and has a feature of convenient implementation.

In an implementation of the second aspect, the forming a first dielectric layer includes: forming the first dielectric layer on an inner wall surface of the first via segment, so that the first dielectric layer covers the inner wall surface of the first via segment; and removing the first dielectric layer from the bottom surface of the first via segment.

The first dielectric layer is removed from the bottom surface of the first via segment, and then the second via segment located in the substrate is formed, so that it can be ensured that a side wall surface of the first via segment is always covered with the first dielectric layer. In the process of forming the second via segment, the first dielectric layer protects the stack structure, and the mask structure is not transversely etched, that is, no undercut is generated during undercutting. In this way, when the conductive layer is formed, it can be ensured that the formed conductive layer has a continuous structure, to ensure electrical performance of the chip.

In an implementation of the second aspect, when the second via segment is formed, an edge of the first dielectric layer coincides with an edge of the second via segment at a location at which the first dielectric layer is connected to the second via segment.

The chip prepared in this way ensures that the side wall surface of the first via segment is always covered with the first dielectric layer, to protect the stack structure. In addition, the edge of the first dielectric layer coinciding with the edge of the second via segment can ensure that a size of the insulation layer does not suddenly change at the location at which the first dielectric layer is connected to the second via segment. In this way, a size of the conductive layer does not suddenly change, and this helps ensure electrical performance of the chip.

In an implementation of the second aspect, when the conductive layer is formed, a first surface of the conductive layer and the surface that is of the mask structure and that is away from the substrate are on a same plane, and a second surface of the conductive layer and the surface that is of the substrate and that is away from the mask structure are on a same plane. The first surface is a surface that is of the conductive layer and that is parallel to the substrate and away from the substrate, and the second surface is a surface that is of the conductive layer and that is parallel to the substrate and away from the mask structure.

For the chip prepared in this way, the conductive layer can be connected to a device disposed on a side that is of the substrate and that is away from the mask structure, and can also be connected to a device disposed on a side that is of the mask structure and that is away from the substrate, so that the conductive layer is electrically connected to a plurality of devices.

In an implementation of the second aspect, the forming a first dielectric layer includes: sequentially stacking, on the side wall of the first via segment in a radial direction of the via, a plurality of layers in a multi-layer structure.

In an implementation of the second aspect, after the insulation layer is formed and before the conductive layer is formed, the preparation method further includes: forming a diffusion barrier layer on the insulation; forming an adhesion layer on the diffusion barrier layer; and forming a seed layer on the adhesion layer. The forming a conductive layer includes: forming the conductive layer in an area enclosed by the seed layer.

In an implementation of the second aspect, the forming a stack structure includes: sequentially stacking a plurality of layers in a multi-layer structure on the substrate.

In an implementation of the second aspect, the forming a stack structure includes: sequentially stacking a first oxide layer, a silicon nitride layer, a second oxide layer, a dielectric material layer, and a third oxide layer on the substrate.

In an implementation of the second aspect, a metal layer is disposed on the surface that is of the mask structure and that is away from the substrate and/or the surface that is of the substrate and that is away from the mask structure, and the metal layer is electrically connected to the conductive layer.

In an implementation of the second aspect, when the first dielectric layer is formed, the substrate has a higher selection ratio relative to the first dielectric layer.

A higher selection ratio of the substrate relative to the first dielectric layer indicates that when a second hollow-out area is formed by etching the substrate, the first dielectric layer is less etched, and the mask structure is less transversely etched, so that reliability of the first dielectric layer for protecting the stack structure is improved.

In an implementation of the second aspect, when the conductive layer is formed, the method includes: electroplating metal on an inner wall surface of the filling space enclosed by the seed layer, to form the conductive layer.

Through electroplating, metal materials can be evenly stacked on a surface of the seed layer, to form the conductive layer with the continuous structure, so as to ensure electrical performance of the chip.

In an implementation of the second aspect, when the via is formed and the first dielectric layer is removed from the bottom surface of the via, a same etching cavity is used.

The same etching cavity is used, so that replacement of the etching cavity is avoided, and machining precision can be ensured to a maximum extent.

In an implementation of the second aspect, after the conductive layer is formed in the filling space enclosed by the first dielectric layer, the preparation method further includes: a graying step of placing the chip in a graying machine to remove a by-product of the chip in the preparation process; and a cleaning step of placing the chip in a cleaning machine to remove a by-product of the chip in the preparation process.

According to a third aspect, an electronic device is provided. The electronic device includes a circuit board and the chip provided in the first aspect, and the chip is disposed on the circuit board.

### BRIEF DESCRIPTION OF DRAWINGS

FIG. 1a is a diagram of a structure of an electronic device according to an embodiment of this application;
FIG. 1b is a diagram of a structure of a chip in the electronic device provided in FIG. 1a;
FIG. 2 is a diagram of a structure of a chip according to an embodiment of this application;
FIG. 3 is a splitting diagram of the chip shown in FIG. 2;
FIG. 4 is a diagram of forming an undercut on a chip;
FIG. 5 is a diagram of a structure of another chip according to an embodiment of this application;
FIG. 6 is a diagram of a structure of another chip according to an embodiment of this application;
FIG. 7 is a diagram of a structure of another chip according to an embodiment of this application;
FIG. 8 is a diagram of a structure of another chip according to an embodiment of this application;
FIG. 9 is a process flowchart of a chip preparation method according to an embodiment of this application;
FIG. 10a is a process structural diagram of a chip preparation method according to an embodiment of this application;
FIG. 10b is a process structural diagram of a chip preparation method according to an embodiment of this application;
FIG. 10c is a process structural diagram of a chip preparation method according to an embodiment of this application;
FIG. 10d is a process structural diagram of a chip preparation method according to an embodiment of this application;
FIG. 10e is a process structural diagram of a chip preparation method according to an embodiment of this application;
FIG. 10f is a process structural diagram of a chip preparation method according to an embodiment of this application;
FIG. 11 is a process flowchart of a chip preparation method according to an embodiment of this application;
FIG. 12a is a process structural diagram of a chip preparation method according to an embodiment of this application;
FIG. 12b is a process structural diagram of a chip preparation method according to an embodiment of this application;
FIG. 13 is a process flowchart of a chip preparation method according to an embodiment of this application;
FIG. 14a is a process structural diagram of a chip preparation method according to an embodiment of this application;
FIG. 14b is a process structural diagram of a chip preparation method according to an embodiment of this application;
FIG. 15 is a process flowchart of a chip preparation method according to an embodiment of this application;
FIG. 16a is a process structural diagram of a chip preparation method according to an embodiment of this application;
FIG. 16b is a process structural diagram of a chip preparation method according to an embodiment of this application;
FIG. 16c is a process structural diagram of a chip preparation method according to an embodiment of this application;
FIG. 17 is a process flowchart of a chip preparation method according to an embodiment of this application;
FIG. 18a is a process structural diagram of a chip preparation method according to an embodiment of this application;
FIG. 18b is a process structural diagram of a chip preparation method according to an embodiment of this application;
FIG. 18c is a process structural diagram of a chip preparation method according to an embodiment of this application;
FIG. 19 is a process structural diagram of a chip preparation method according to an embodiment of this application; and
FIG. 20 is a process structural diagram of a chip preparation method according to an embodiment of this application.

Reference numerals:
10: electronic device;
100: chip; 200: circuit board;
120: first device; 130: solder ball; 140: second device; 150: metal layer;
110: substrate; 110a: lower surface; 111: first part;
1: stack structure; 11: first oxide layer; 12: silicon nitride layer; 13: second oxide layer; 14: dielectric material layer; 15: third oxide layer;
2: mask structure; 2a: upper surface;
3: first dielectric layer;
4: conductive layer; 4a: first surface; 4b: second surface;
5: via; 51: first via segment; 51a: side wall; 51b: first bottom surface; 52: second via segment; 52a: second bottom surface;
6: insulation layer;
7: first hole; and
8: second hole.

### DESCRIPTION OF EMBODIMENTS

The following describes the technical solutions in embodiments of this application with reference to the accompanying drawings in embodiments of this application. In descriptions of this application, unless otherwise specified, "/" represents an "or" relationship between associated objects. For example, A/B may represent A or B. In this application, "and/or" describes only an association relationship between associated objects and represents that three relationships may exist. For example, A and/or B may represent the following three cases: Only A exists, both A and B exist, and only B exists, where A or B may be singular or plural. In addition, in the descriptions of this application, "a plurality of" means two or more than two unless otherwise specified. "At least one of the following items (pieces)" or a similar expression thereof means any combination of these items, including any combination of singular items (pieces) or plural items (pieces). For example, at least one item (piece) of a, b, or c may indicate: a, b, c, a and b, a and c, b and c, or a, b, and c, where a, b, and c may be singular or plural. In addition, to clearly describe the technical solutions in embodiments of this application, terms such as "first" and "second" are used in embodiments of this application to distinguish between same items or similar items that provide basically same functions or purposes. A person skilled in the art may understand that the words such as "first" and "second" do not limit a quantity or an execution sequence, and the words such as "first" and "second" do not indicate a definite difference. In addition, in embodiments of this application, terms such as "example" or "for example" are used to give an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner for ease of understanding.

An embodiment of this application provides an electronic device, and an integrated chip is disposed in the electronic device. Specifically, the electronic device may be a mobile phone, a biological application device, or the like. A specific form of the electronic device is not specially limited in embodiments of this application.

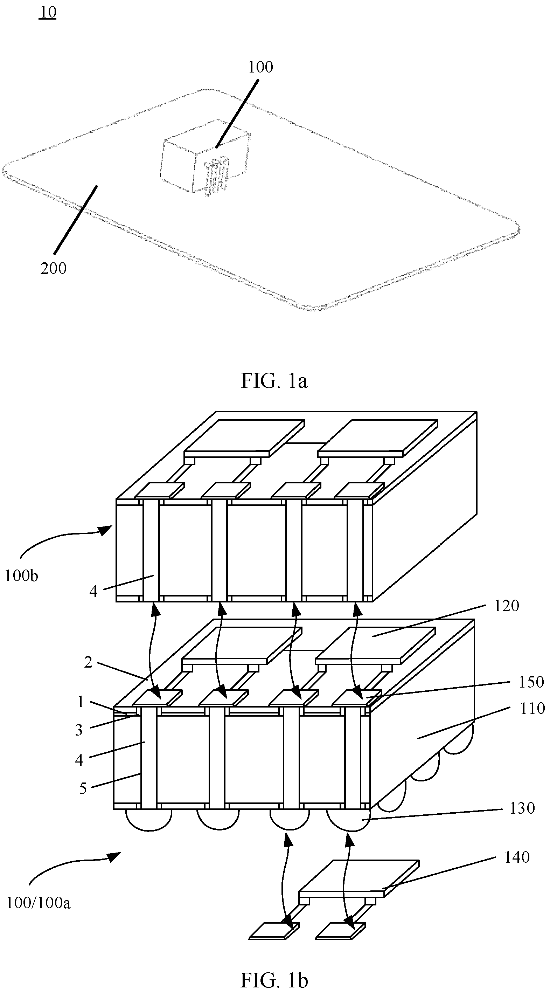

FIG. 1a is a diagram of a structure of an electronic device according to an embodiment of this application. As shown in FIG. 1a, the electronic device includes a chip 100 and a circuit board 200. The chip 100 is disposed on the circuit board 200. The chip 100 is connected to the circuit board 200 in a plurality of manners, for example, through welding. Specifically, the chip 100 may be disposed in the electronic device as a memory, or the chip 100 may be disposed in the electronic device as a controller.

It may be understood that FIG. 1a shows only some components included in the electronic device 10 as an example, and actual shapes, actual sizes, actual locations, and actual structures of these components are not limited by FIG. 1a.

FIG. 1b is a diagram of a structure of the chip in the electronic device provided in FIG. 1a. As shown in FIG. 1b, in some embodiments, the chip 100 includes a substrate 110, a stack structure 1, a mask structure 2, a conductive layer 4, a via 5, a first device 120, a solder ball 130, a second device 140, and a metal layer 150. The stack structure 1 and the mask structure 2 are sequentially disposed on the substrate 110, the via 5 penetrates the mask structure 2, the stack structure 1, and the substrate 110 in a direction perpendicular to the substrate 110, and the conductive layer 4 is formed in the via 5. The first device 120 disposed on an upper surface of the mask structure 2 is electrically connected to the conductive layer 4 through the metal layer 150. The second device 140 disposed on a lower surface of the substrate 110 is electrically connected to the conductive layer 4 through the solder ball 130. In this way, vertical electrical interconnection between the first device 120 and the second device 140 in the chip 100 is implemented. "Vertical" in the vertical electrical interconnection means the direction perpendicular to the substrate.

The chip provided in this embodiment of this application can further implement vertical electrical interconnection between a plurality of chips. As shown in FIG. 1b, the conductive layer 4 of the first chip 100a is connected to a conductive layer 4 of a second chip 100b through the metal layer 150, to implement vertical electrical interconnection between the first chip 100a and the second chip 100b.

Through vertical electrical interconnection between internal components of the chip and vertical electrical interconnection between the plurality of chips, three-dimensional stacking of the chips can be implemented, so that the chips have higher density and space utilization, a higher level of integration and better performance of the chips are implemented, and requirements of the electronic device for a smaller size and higher performance are further met.

For better electrical performance of the chip, as a key structure for implementing vertical electrical interconnection between the devices and between the chips, the conductive layer needs to have a continuous structure. Specifically, if there is a gap or a hole in a part of the conductive layer, resistance of the conductive layer is affected, thereby affecting electrical performance of the chip. Embodiments of this application provide a chip, to ensure that a material of a conductive layer is evenly distributed, and the conductive layer has a continuous structure and no breakage, so as to ensure electrical performance of the chip. The following provides detailed descriptions with reference to the accompanying drawings.

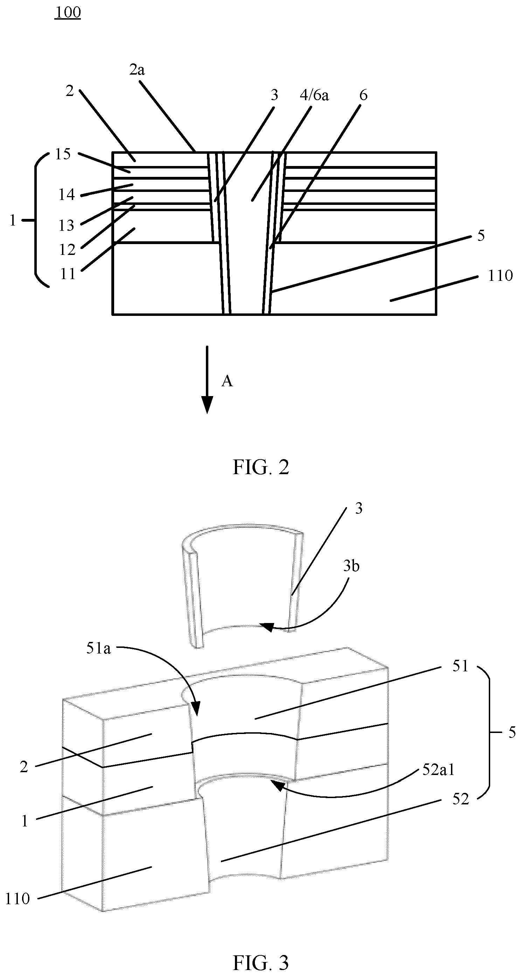

FIG. 2 is a diagram of a structure of a chip according to an embodiment of this application. As shown in FIG. 2, a chip 100 includes a substrate 110, a stack structure 1, a mask structure 2, a first dielectric layer 3, a conductive layer 4, and an insulation layer 6.

The substrate 110 may be made of a plurality of materials, including at least one of monocrystalline silicon (Si), monocrystalline germanium (Ge), gallium arsenide, indium phosphide, an III-V compound semiconductor material, an II-VI compound semiconductor material, or another semiconductor material known in the art. Alternatively, the substrate 110 may be made of a non-conductive material like glass, plastic, or a sapphire wafer.

The stack structure 1 is stacked on the substrate 110. The stack structure 1 may be a multi-layer structure. In an implementation, the stack structure 1 includes a first oxide layer 11, a silicon nitride layer 12, a second oxide layer 13, a dielectric material layer 14, and a third oxide layer 15 that are sequentially stacked on the substrate 110. The first oxide layer 11, the second oxide layer 13, and the third oxide layer 15 may be made of a same material, or may be made of different materials. A material of the dielectric material layer 14 is a low-k dielectric material. The silicon nitride layer 12 has a function of masking impurity contamination. For example, materials of the first oxide layer 11, the second oxide layer 13, and the third oxide layer 15 are all silicon dioxide (SiO₂), and the material of the dielectric material layer 14 is silicon nitride (Si₃N₄).

The material of the dielectric material layer 14 has a feature of low-k (low-k) dielectric, and the dielectric material layer is also referred to as a low-k layer. The low-k layer is made of a porous material and is easy to be etched.

The mask structure 2 is stacked on the stack structure 1, and is configured to implement a plurality of photoetching processes. Specifically, an image on a photoresist may be transferred onto the mask structure 2 through etching, and then the image on the mask structure 2 is transferred onto the stack structure 1 and the substrate 110 through etching.

The mask structure 2 may be made of an inorganic film material generated through chemical vapor deposition (Chemical Vapor Deposition, CVD). The mask structure 2 may be a multi-layer structure, and a used material usually includes titanium nitride (TiN), silicon nitride (Si₃N₄), silicon dioxide (SiO₂), and the like. In an implementation, the mask structure may include at least one of a titanium nitride layer, a silicon nitride layer, an aluminum oxide layer, or a silicon dioxide layer.

With reference to FIG. 2 and FIG. 3, in some embodiments, a via 5 extending in a direction A perpendicular to the substrate is provided on an upper surface 2a that is of the mask structure 2 and that is away from the substrate 110, and the via 5 penetrates the mask structure 2, the stack structure 1, and the substrate 110. The via 5 may be a round hole, or may be a square hole, or may be a tapered hole whose cross-sectional area gradually decreases in the direction A perpendicular to the substrate, as shown in FIG. 2. A shape of the via 5 is not specifically limited in this application.

The via 5 includes a first via segment 51 that penetrates the mask structure 2 and the stack structure 1 and a second via segment 52 that penetrates the substrate. A process of forming the first via segment 51 is a process of transferring the image on the photoresist to the mask structure 2 and the stack structure 1. A process of forming the second via segment 52 is a process of transferring the image on the mask structure 2 to the substrate 110 through etching.

Because the image on the photoresist needs to be first transferred to the mask structure 2, etching starts from a side that is of the mask structure 2 and that is away from the substrate 110. In other words, the first via segment 51 needs to be formed first, and then the second via segment 52 is formed. When the first via segment 51 is formed, the substrate 110 is not affected. However, when the second via segment 52 is formed, the substrate 110 is etched from the first via segment 51 in the direction A perpendicular to the substrate 110. Therefore, a side wall of the first via segment 51 is also affected by etching. In other words, the mask structure 2 and the stack structure 1 are also affected.

To protect the stack structure 1 in the process of forming the second via segment 52, the side wall 51a of the first via segment 51 is covered with the first dielectric layer 3. In this way, in the process of forming the second via segment 52, when transverse etching occurs, the first dielectric layer 3 is first etched. However, parts that are of the mask structure 2 and the stack structure 1 and that are located on the side wall 51a of the first via segment 51 are not etched, and therefore are not damaged.

The first dielectric layer 3 may be made of a plurality of materials, for example, a silicon dioxide material, or another material that forms a side wall protection layer, including but not limited to at least one of silicon carbonitride (SiCN), silicon oxide (SION), silicon oxide (SiO₂), silicon nitride (SIN), silicon oxycarbonitride (SIOCN), silicon carbide (SIC), or silicon oxycarbide (SIOC).

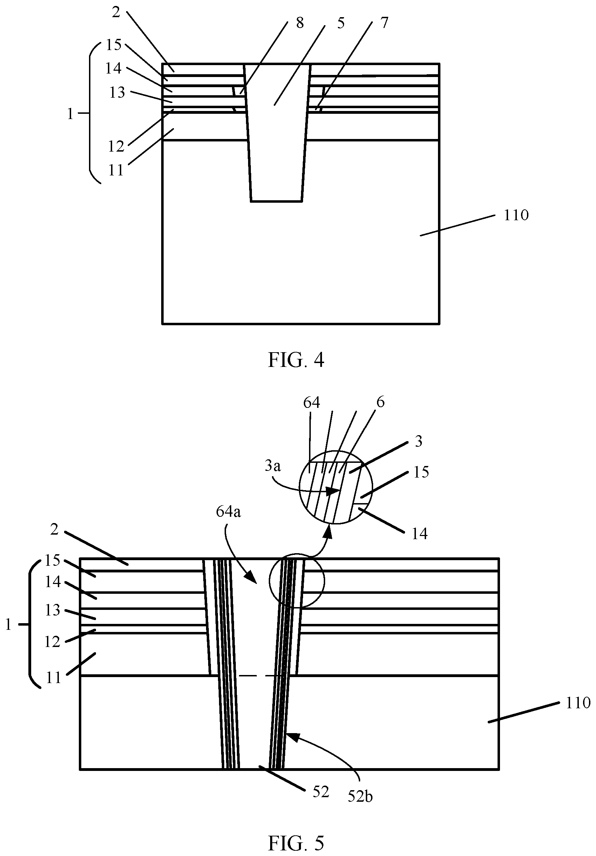

As shown in FIG. 4, in the process of forming the second via segment 52, if there is no first dielectric layer 3 on the side wall 51a of the first via segment 51, the side wall of the first via segment 51 is affected by etching, and transverse etching (the mask structure 2 is etched in a direction parallel to the substrate 110) occurs. The stack structure 1 is a multi-layer structure, and materials of every two adjacent layers of structures are different. Therefore, under a same etching condition, etching rates of every two adjacent layers of structures are different. In this case, a film layer with a higher etching rate is concave relative to a film layer with a lower etching rate, and an undercut is formed. For example, compared with the first oxide layer 11, the second oxide layer 13, and the third oxide layer 15, the dielectric material layer 14 and the silicon nitride layer 12 have higher etching rates, where more materials are etched in a same time period. In this case, because etched materials of the silicon nitride layer 12 are more than etched materials of the first oxide layer 11 and the second oxide layer 13, a first hole 7 is formed on the side wall of the first via segment 51. Because etched materials of the dielectric material layer 14 are more than etched materials of the second oxide layer 13 and the third oxide layer 15, a second hole 8 is formed on the side wall of the first via segment 51.

Therefore, the first dielectric layer 3 is covered on the side wall 51a of the first via segment 51, so that the mask structure 2 can be protected. In this way, in the process of forming the via 5, the stack structure 1 is not undercut.

In an implementation, the first dielectric layer 3 may be formed in a vapor deposition manner. The first dielectric layer 3 obtained in this way completely covers the side wall 51a of the first via segment 51. Even if there is a disadvantage (for example, a depression) on the side wall 51a of the first via segment 51, the first dielectric layer 3 can still completely cover the disadvantage, so that the first dielectric layer 3 is of a continuous structure without holes.

To enhance reliability of protecting the mask structure 2 by the first dielectric layer 3, in some embodiments, the substrate 110 has a higher etching selection ratio relative to the first dielectric layer 3. In this way, when the second via segment 52 is formed, the first dielectric layer 3 is less etched, to ensure that the stack structure 1 is not undercut. The etching selection ratio is represented as a ratio of an etching rate of an etched material to an etching rate of another material. A high selection ratio means that only a layer of material that needs to be etched is etched.

Because the substrate 110 cannot be in contact with the conductive layer 4, before the conductive layer 4 is formed, the insulation layer 6 needs to be covered on the first dielectric layer 3 and the side wall of the second via segment 52.

Because the first dielectric layer 3 is disposed between the insulation layer 6 and the side wall 51a of the first via segment 51, a structure of the insulation layer 6 is not affected by a damage or a disadvantage on the side wall 51a of the first via segment 51, and there is no hole or other disadvantage that causes discontinuity of the insulation layer 6 on the insulation layer 6.

Still refer to FIG. 2 and FIG. 3.

Conductive layer 4: The conductive layer 4 is formed in filling space 6a enclosed by the insulation layer 6. In an implementation, the conductive layer 4 is formed through electroplating. Because there is no hole or other disadvantage that causes discontinuity of the insulation layer 6 on the insulation layer 6, structural continuity of the conductive layer 4 can be implemented, to ensure electrical performance of the chip 100. It may be understood that the conductive layer 4 may be a pillar structure formed in the filling space 6a, or may be a thin film structure formed in the filling space 6a.

For an even and continuous structure of the formed conductive layer, as shown in FIG. 5, in some embodiments, the chip further includes a diffusion barrier layer 62, an adhesion layer 63, and a seed layer 64. The insulation layer 6 is covered with the diffusion barrier layer 62, the diffusion barrier layer 62 is covered with the adhesion layer 63, the adhesion layer 63 is covered with the seed layer 64, and the conductive layer 4 is formed in an area 64a enclosed by the seed layer 64.

To avoid a sudden change in a size of the conductive layer 4 near a location at which the first dielectric layer 3 is connected to the second via segment 52, which effects a resistance of the conductive layer 4, thereby affecting electrical performance of the chip 100, in some embodiments, an edge 3b of the first dielectric layer 3 coincides with an edge 52a1 of the second via segment 52 at the location at which the first dielectric layer 3 is connected to the second via segment 52. In this way, it can be ensured that a size transition of the conductive layer 4 is natural near the location at which the first dielectric layer 3 is connected to the second via segment 52, and it can also be ensured that the side wall surface 51a of the first via segment 51 is always covered with the first dielectric layer 3, to protect the stack structure 1.

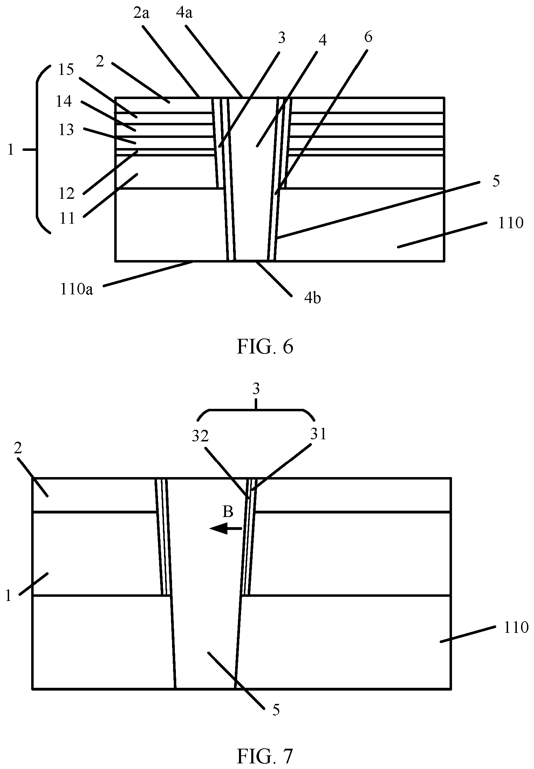

For an electrical connection between the conductive layer 4 and a device (or chip), as shown in FIG. 6, in some embodiments, the conductive layer 4 has a first surface 4a and a second surface 4b that are parallel to the substrate. The first surface 4a is a surface away from the substrate 110, and the second surface 4b is a surface away from the mask structure 2; the first surface 4a and the upper surface 2a that is of the mask structure 2 and that is away from the substrate 110 are on a same plane; and the second surface 4b and the lower surface 110a that is of the substrate 110 and that is away from the mask structure 2 are on a same plane. The conductive layer 4 can be connected to a device or a chip disposed on a side that is of the substrate 110 and that is away from the mask structure 2, and can also be connected to a device or a chip disposed on a side that is of the mask structure 2 and that is away from the substrate 110, so that the conductive layer 4 is electrically connected to a plurality of devices or chips.

In some other embodiments, the second surface 4b of the conductive layer 4 may extend outside the lower surface 110a that is of the substrate 110 and that is away from the mask structure 2. In other words, the conductive layer 4 is exposed outside the substrate 110 for a distance. In some scenarios, the conductive layer is not directly electrically connected to the device (or chip), but is electrically connected to the device (or chip) through a metal layer, or is electrically connected to the device (or chip) through a solder ball (as shown in FIG. 1a).

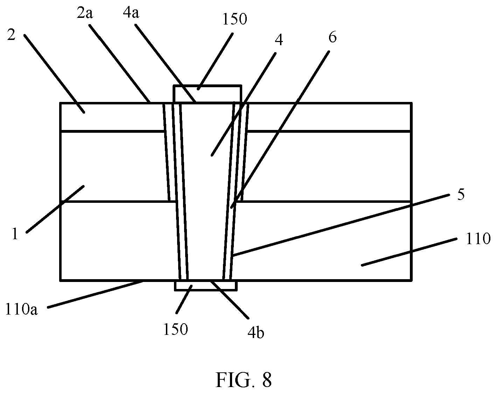

As shown in FIG. 8, in some embodiments, a metal layer 150 is disposed on the upper surface 2a that is of the mask structure 2 and that is away from the substrate 110 and/or the lower surface 110a that is of the substrate 110 and that is away from the mask structure 2, and the metal layer 150 is electrically connected to the conductive layer 4. In an implementation, as shown in FIG. 8, the metal layer 150 is disposed on the upper surface 2a that is of the mask structure 2 and that is away from the substrate 110 and on the lower surface 110a that is of the substrate 110 and that is away from the mask structure 2, and the metal layer 150 is located on the first surface 4a and the second surface 4b of the conductive layer 4.

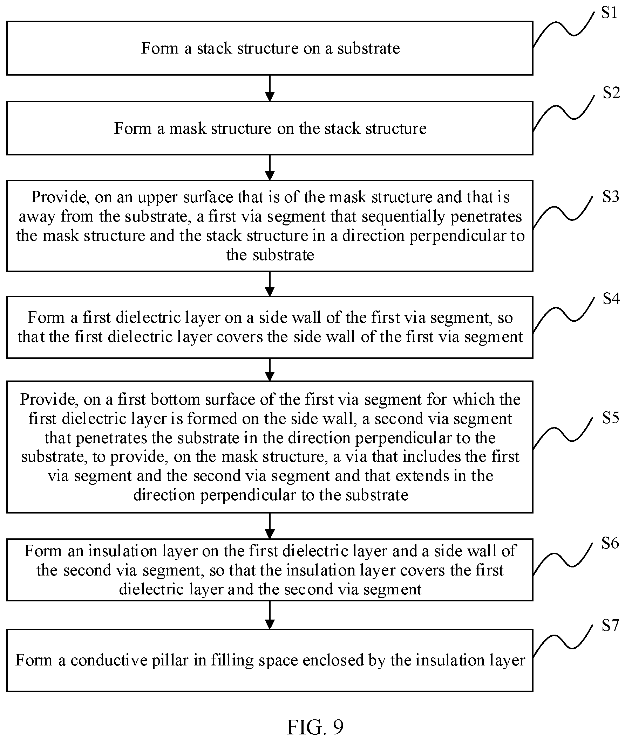

To further improve reliability of protecting the substrate 110 by the first dielectric layer 3, as shown in FIG. 7, in some embodiments, the first dielectric layer 3 is of a multi-layer structure, and a plurality of layers in the multi-layer structure are sequentially stacked on the side wall 51a of the first via segment 51 in a radial direction B of the via 5. As shown in FIG. 9, in an implementation, the first dielectric layer 3 includes a first film layer 31 and a second film layer 32, and the first film layer 31 and the second film layer 32 are sequentially stacked on the side wall 51a of the first via segment 51 in the radial direction B of the via 5 (as shown in FIG. 3).

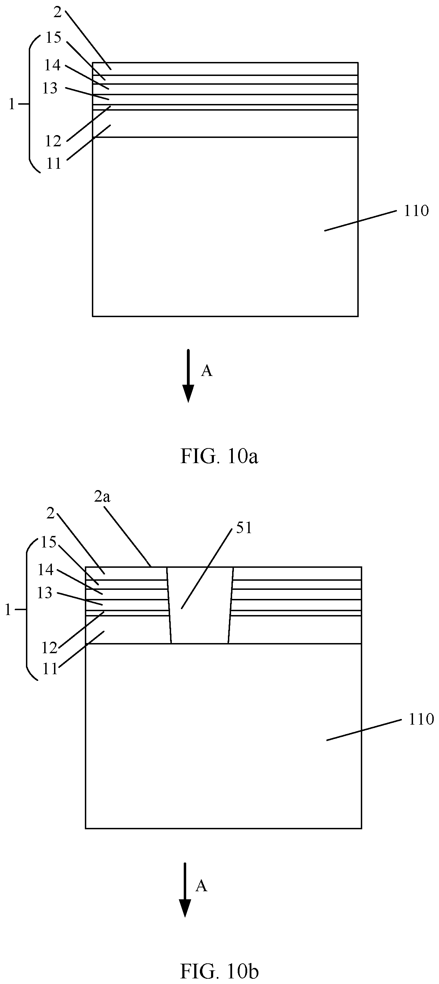

In the foregoing, the first dielectric layer is formed between the first via segment and the insulation layer. When transverse etching occurs, the first dielectric layer is first etched, to protect a part that is of the stack structure and that is located in the first via segment from being etched, and avoid forming an undercut on the side wall of the first via segment. In addition, the structure of the insulation layer is not affected by a damage or a disadvantage on an inner wall surface of the first via segment, and there is no hole or other disadvantage that causes discontinuity of the insulation layer on the insulation layer. Therefore, structural continuity of the conductive layer can be implemented, to ensure electrical performance of the chip. Embodiments of this application further provide a chip preparation method. The following specifically describes an implementable chip preparation method with reference to a process flowchart shown in FIG. 9 and process structural diagrams in FIG. 10a to FIG. 10f. As shown in FIG. 9, the process flowchart includes steps S1 to S7.

S1: As shown in FIG. 10a, form a stack structure 1 on a substrate 110.

As shown in FIG. 10a, in some embodiments, when the stack structure 1 is formed, a first oxide layer 11, a silicon nitride layer 12, a second oxide layer 13, a dielectric material layer 14, and a third oxide layer 15 are sequentially stacked on the substrate 110.

S2: As shown in FIG. 10a, form a mask structure 2 on the stack structure 1.

S3: As shown in FIG. 10b, provide, on an upper surface 2a that is of the mask structure 2 and that is away from the substrate 110, a first via segment 51 that penetrates the mask structure 2 and the stack structure 1 in a direction A perpendicular to the substrate 110.

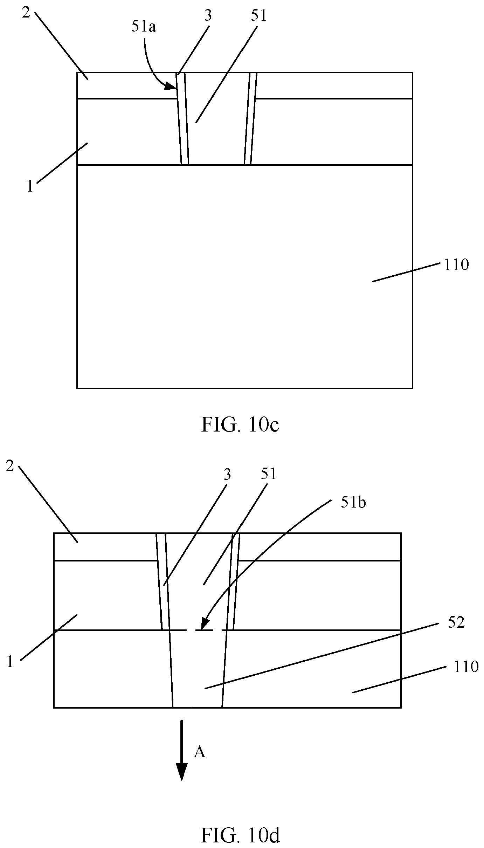

S4: As shown in FIG. 10c, form a first dielectric layer 3 on a side wall 51a of the first via segment 51, so that the first dielectric layer 3 covers the side wall 51a of the first via segment 51.

S5: As shown in FIG. 10d, provide, on a first bottom surface 51b of the first via segment 51 for which the first dielectric layer 3 is formed on the side wall 51a, a second via segment 52 that penetrates the substrate 110 in the direction A perpendicular to the substrate 110, to provide, on the mask structure 2, a via 5 that includes the first via segment 51 and the second via segment 52 and that extends in the direction A perpendicular to the substrate 110.

In an implementation, when the second via segment 52 is formed, an edge of the first dielectric layer 3 coincides with an edge of the second via segment 52 at a location at which the first dielectric layer 3 is connected to the second via segment 52.

In an implementation, the substrate 110 may be a silicon plate, and is etched in a silicon etching cavity, to form the second via segment 52 in the substrate 110.

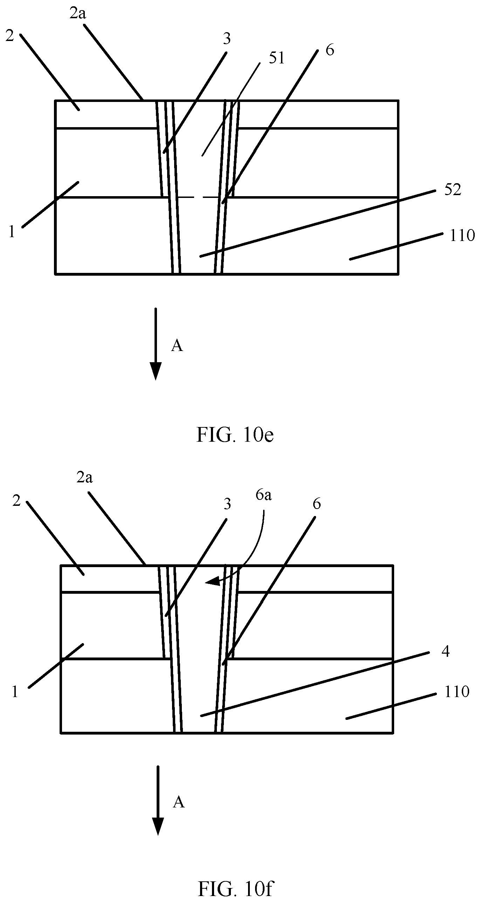

S6: As shown in FIG. 10e, form an insulation layer 6 on the first dielectric layer 3 and a side wall of the second via segment 52, so that the insulation layer 6 covers the first dielectric layer 3 and the second via segment 52.

In an implementation, the insulation layer 6 is grown in a thermal oxidation manner, and a material of the insulation layer 6 may be silicon dioxide.

S7: As shown in FIG. 10f, form a conductive layer 4 in filling space 6a enclosed by the insulation layer 6.

In this embodiment of this application, steps S3 to S5 are performed, to complete a process of transferring an image on a photoresist to the mask structure 2 and the stack structure 1, and then transferring the image on the mask structure 2 to the substrate 110 through etching. In this embodiment of this application, step S4 is performed after S3 and before S5. When the second via segment 52 is formed, the first dielectric layer 3 can protect the mask structure 2, and the mask structure 2 is not transversely etched, to avoid forming an undercut on the side wall 51a of the first via segment 51. In this way, when the insulation layer 6 is formed on the first dielectric layer 3 and the second via segment 52, because no undercut is formed on the side wall 51a of the first via segment 51, there is no hole or other disadvantage that causes discontinuity of the insulation layer 6 on the insulation layer 6. When the conductive layer 4 is formed in the filling space 6a enclosed by the insulation layer 6, structural continuity of the conductive layer 4 can be implemented, to ensure electrical performance of the chip. In this embodiment of this application, a problem of an undercut on the stack structure 1 can be fundamentally resolved without changing process steps before step S3 and after step S5.

The following provides an embodiment of forming the first dielectric layer on the side wall of the first via segment.

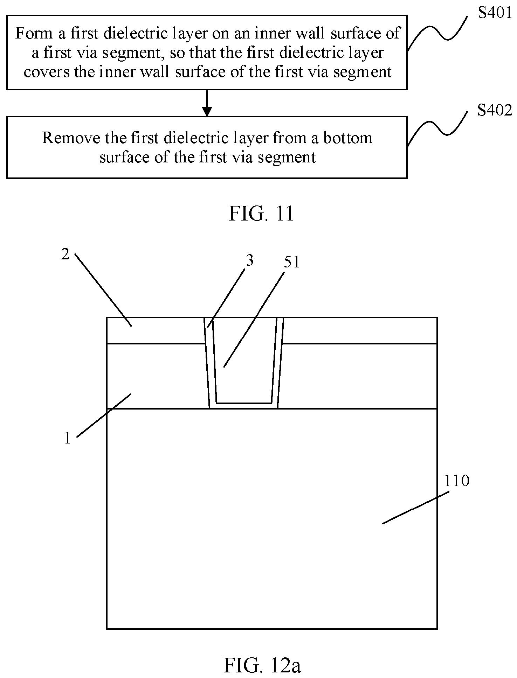

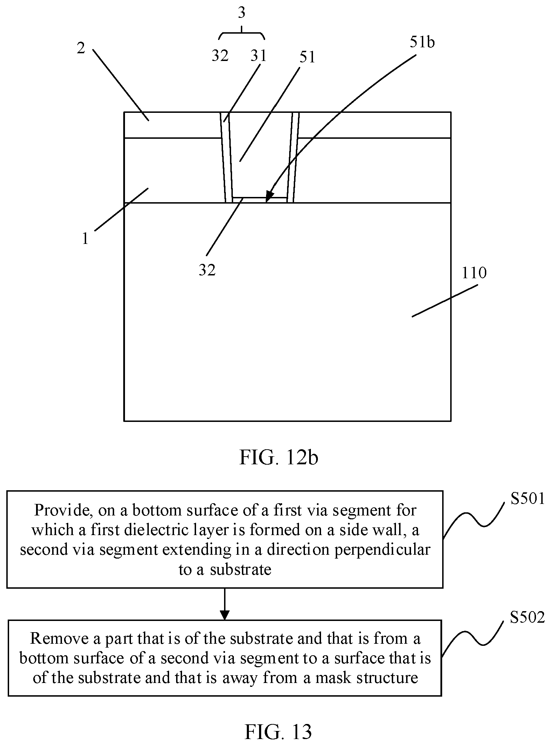

In some embodiments, when step S4 is performed, steps S401 and S402 are included. The following specifically describes an implementable chip preparation method with reference to a process flowchart shown in FIG. 11 and process structural diagrams in FIG. 12a and FIG. 12b. As shown in FIG. 11, the process flowchart includes steps S401 and S402.

S401: As shown in FIG. 12a, form the first dielectric layer 3 on an inner wall surface of the first via segment 51, so that the first dielectric layer 3 covers the inner wall surface of the first via segment 51.

S402: As shown in FIG. 12b, remove the first dielectric layer 3 from the first bottom surface 51b of the first via segment 51.

In an implementation, the first dielectric layer 3 located on the first bottom surface 51b of the first via segment 51 may be removed by using a dielectric etching cavity.

In an implementation, the first dielectric layer 3 located on the first bottom surface 51b of the first via segment 51 may be removed by using a TSV etching cavity. In this way, when step S5 and step S402 are performed, a same etching cavity may be used, so that replacement of the etching cavity is avoided, and machining precision can be ensured to a maximum extent.

As shown in FIG. 12b, the first dielectric layer 3 includes a first part 31 covering the side wall of the first via segment 51 and a second part 32 located on the first bottom surface 51b of the first via segment 51, and the second part 32 is removed.

Compared with directly forming the first dielectric layer 3 on the side wall 51a of the first via segment 51, forming the first dielectric layer 3 by using the preparation method in steps S401 and S402 is less difficult and easy to implement, and is conducive to mass production of the chip.

When step S5 is performed, the second via segment 52 may directly penetrate the substrate 110 during forming. However, when a thickness of the substrate 110 is large, or the substrate 110 is not suitable for penetration, the second via segment 52 may not penetrate the substrate 110 first during forming. Instead, after the second via segment 52 is formed, an extra material of the substrate 110 is removed, to obtain a structure in which the second via segment 52 penetrates the substrate 110.

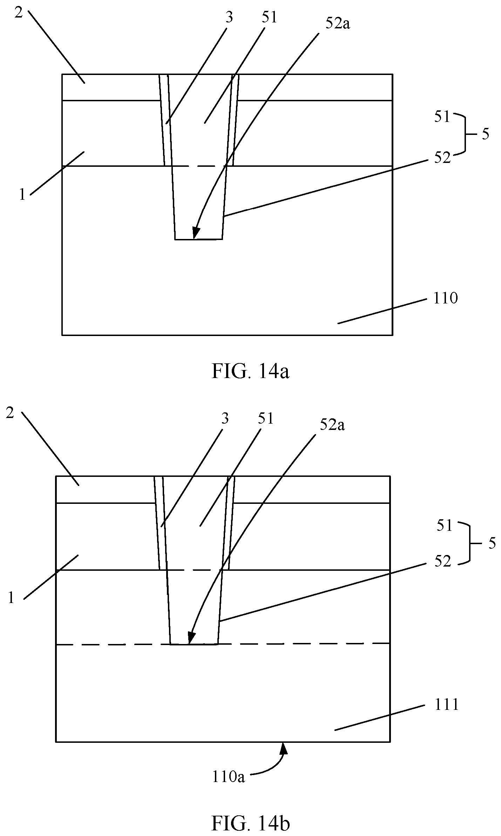

In some embodiments, when step S5 is performed, steps S501 and S502 are included. The following specifically describes an implementable chip preparation method with reference to a process flowchart shown in FIG. 13 and process structural diagrams in FIG. 14a and FIG. 14b. As shown in FIG. 13, the process flowchart includes steps S501 and S502.

S501: As shown in FIG. 14a, provide, on the first bottom surface 51b of the first via segment 51 for which the first dielectric layer 3 is formed on the side wall 51a, the second via segment 52 extending in the direction A perpendicular to the substrate 110, where in this case, the second via segment 52 does not penetrate the substrate 110.

S502: As shown in FIG. 14b, remove a part 11 that is of the substrate 110 and that is from a second bottom surface 52a of the second via segment 52 to the lower surface 110a that is of the substrate 110 and that is away from the mask structure 2, where in this case, as shown in FIG. 10d, the second via segment 52 penetrates the substrate 110.

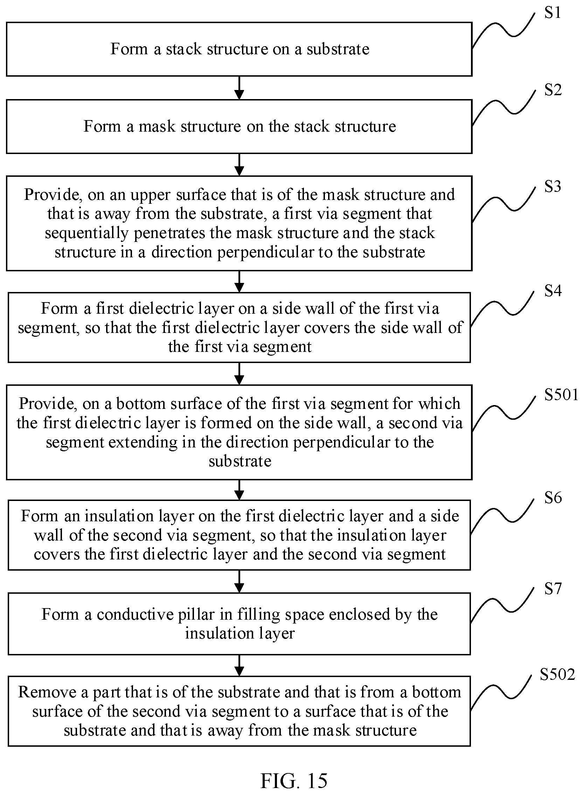

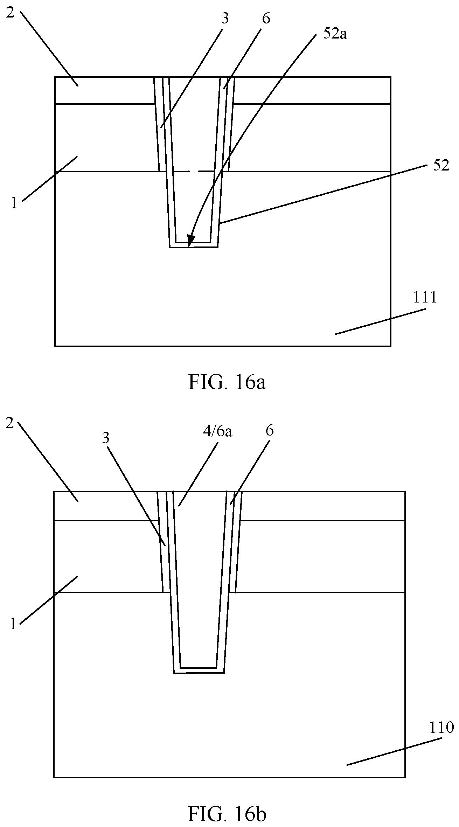

In some other embodiments, as shown in FIG. 15, after steps S1 to S4 and step S501 are performed, and before step S502 is performed, step S6 and step S7 are first performed. The following specifically describes an implementable chip preparation method with reference to a process flowchart shown in FIG. 15 and process structural diagrams in FIG. 16a to FIG. 16c.

S1: As shown in FIG. 10a, form a stack structure 1 on a substrate 110.

S2: As shown in FIG. 10a, form a mask structure 2 on the stack structure 1.

S3: As shown in FIG. 10b, provide, on an upper surface 2a that is of the mask structure 2 and that is away from the substrate 110, a first via segment 51 that penetrates the mask structure 2 and the stack structure 1 in a direction A perpendicular to the substrate 110.

S4: As shown in FIG. 10c, form a first dielectric layer 3 on a side wall 51a of the first via segment 51, so that the first dielectric layer 3 covers the side wall 51a of the first via segment 51.

S501: As shown in FIG. 14a, provide, on a first bottom surface 51b of the first via segment 51 for which the first dielectric layer 3 is formed on the side wall 51a, a second via segment 52 extending in the direction A perpendicular to the substrate 110, where in this case, the second via segment 52 does not penetrate the substrate 110.

S6: As shown in FIG. 16a, form an insulation layer 6 on the first dielectric layer 3 and a side wall of the second via segment 52, so that the insulation layer 6 covers the first dielectric layer 3 and the second via segment 52.

S7: As shown in FIG. 16b, form a conductive layer 4 in filling space 6a enclosed by the insulation layer 6.

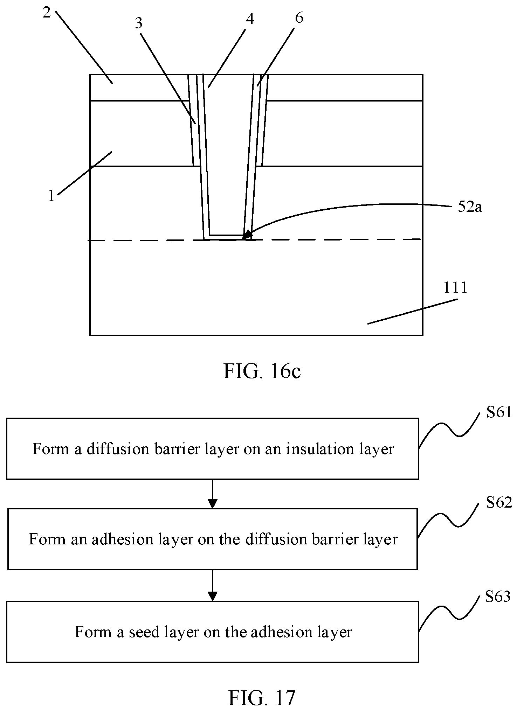

S502: As shown in FIG. 16c, remove a part 11 that is of the substrate 110 and that is from a second bottom surface 52a of the second via segment 52 to a surface that is of the substrate 110 and that is away from the mask structure 2, where in this case, as shown in FIG. 10d, the second via segment 52 penetrates the substrate 110, and the conductive layer 4 is exposed on a surface of the substrate 110.

The following provides a specific implementation of forming the insulation layer.

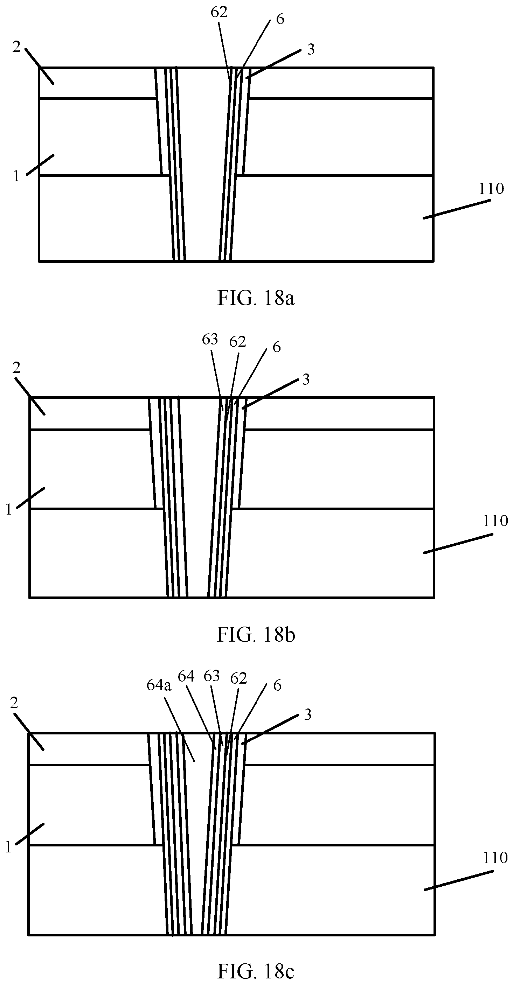

After step S6 is performed, and before step 7 is performed, the preparation method further includes steps S61 to S63. The following specifically describes an implementable chip preparation method with reference to a process flowchart shown in FIG. 17 and process structural diagrams in FIG. 18a to FIG. 18c.

S61: As shown in FIG. 18a, form a diffusion barrier layer 62 on the insulation layer 6.

In an implementation, a plasma enhanced chemical vapor deposition (plasma enhanced chemical vapor deposition, PECVD) method, a subatmospheric chemical vapor deposition (subatmospheric chemical vapor deposition, SACVD) method, an atmospheric pressure chemical vapor deposition (atmospheric pressure chemical vapor deposition, APCVD) method, or a chemical liquid deposition method is used.

S62: As shown in FIG. 18b, form an adhesion layer 63 on the diffusion barrier layer 62.

S63: As shown in FIG. 18c, form a seed layer 64 on the adhesion layer 63.

After steps S61 to S63 are performed, when step S7 is performed, as shown in FIG. 18c, the conductive layer 4 is formed in an area 64a enclosed by the seed layer 64.

To enable the conductive layer to be electrically connected to a device or a chip disposed on a side that is of the substrate and that is away from the mask structure, and enable the conductive layer to be electrically connected to a device or a chip disposed on a side that is of the mask structure and that is away from the substrate, in this embodiment of this application, the conductive layer is exposed by removing a material.

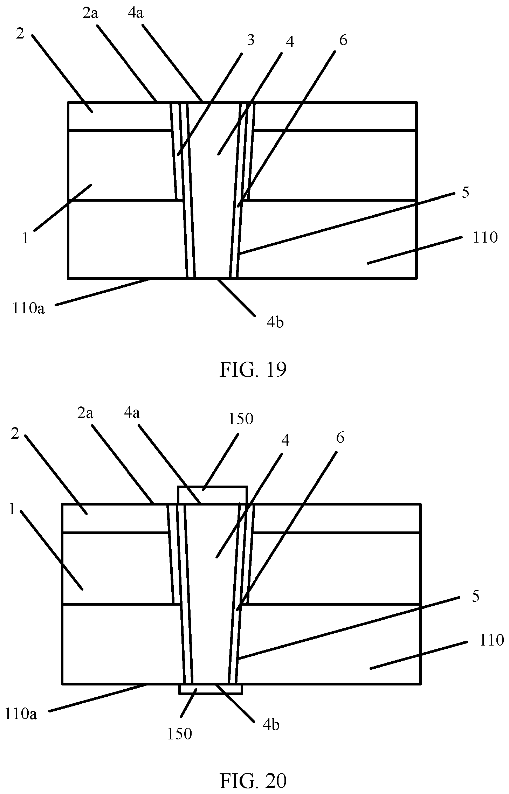

Further, to ensure reliability of an electrical connection between the conductive layer and a device (or chip), as shown in FIG. 19, in some embodiments, after step S7 is performed, the preparation method further includes: when the conductive layer 4 is formed, making a first surface 4a of the conductive layer 4 and an upper surface 2a that is of the mask structure 2 and that is away from the substrate 110 be on a same plane; and making a second surface 4b of the conductive layer 4 and a lower surface 110a that is of the substrate 110 and that is away from the mask structure 2 be on a same plane. The first surface 4a is a surface that is of the conductive layer 4 and that is parallel to the substrate 110 and away from the substrate 110, and the second surface 4b is a surface that is of the conductive layer 4 and that is parallel to the substrate 110 and away from the mask structure 2. In an implementation, in a polishing manner, the first surface 4a of the conductive layer 4 and the upper surface 2a that is of the mask structure 2 and that is away from the substrate 110 may be on the same plane, and the second surface 4b of the conductive layer 4 and the lower surface 110a that is of the substrate 110 and that is away from the mask structure 2 may be on the same plane.

In some scenarios, the conductive layer is not directly electrically connected to the device (or chip), but is electrically connected to the device (or chip) through a metal layer, or is electrically connected to the device (or chip) through a solder ball. As shown in FIG. 20, in some embodiments, a metal layer 150 is disposed on the upper surface 2a that is of the mask structure 2 and that is away from the substrate 110 and/or the lower surface 110a that is of the substrate 110 and that is away from the mask structure 2, and the metal layer 150 is electrically connected to the conductive layer 4.

In the foregoing, in the etching and deposition process, there are residual by-products such as a photoresist and an etching liquid on the chip. To remove the by-products, in some embodiments, the preparation method further includes: a graying step of placing the chip in a graying machine to remove a by-product of the chip in the preparation process; and a cleaning step of placing the chip in a cleaning machine to remove a by-product of the chip in the preparation process.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A chip, comprising:
a substrate;
a stack structure, stacked on the substrate;
a mask structure, stacked on the stack structure, wherein a via extending in a direction perpendicular to the substrate is provided on a surface that is of the mask structure and that is away from the substrate, the via penetrates the mask structure, the stack structure, and the substrate, and the via comprises a first via segment that penetrates the mask structure and the stack structure and a second via segment that penetrates the substrate;
a first dielectric layer, covering a side wall of the first via segment;
an insulation layer, covering a side wall of the second via segment and the first dielectric layer, and enclosing filling space in the via; and
a conductive layer, formed in the filling space.

2. The chip according to claim 1, wherein an edge of the first dielectric layer coincides with an edge of the second via segment at a location at which the first dielectric layer is connected to the second via segment.

3. The chip according to claim 1 or 2, wherein the conductive layer has a first surface and a second surface that are parallel to the substrate, the first surface is a surface away from the substrate, and the second surface is a surface away from the mask structure;
the first surface and the surface that is of the mask structure and that is away from the substrate are on a same plane; and
the second surface and a surface that is of the substrate and that is away from the mask structure are on a same plane.

4. The chip according to any one of claims 1 to 3, wherein the first dielectric layer is of a multi-layer structure; and
a plurality of layers in the multi-layer structure are sequentially stacked on the side wall of the first via segment in a radial direction of the via.

5. The chip according to any one of claims 1 to 4, wherein a material of the first dielectric layer comprises at least one of silicon carbonitride, silicon oxynitride, silicon oxide, silicon nitride, silicon oxycarbonitride, silicon carbide, or silicon oxycarbide.

6. The chip according to any one of claims 1 to 5, wherein the chip further comprises a diffusion barrier layer, an adhesion layer, and a seed layer;
the insulation layer is covered with the diffusion barrier layer;
the diffusion barrier layer is covered with the adhesion layer; and
the adhesion layer is covered with the seed layer, and the seed layer is located between the insulation layer and the conductive layer.

7. The chip according to any one of claims 1 to 6, wherein the stack structure is a multi-layer structure; and
a plurality of layers in the multi-layer structure are sequentially stacked on the substrate.

8. The chip according to claim 7, wherein the stack structure comprises a first oxide layer, a silicon nitride layer, a second oxide layer, a dielectric material layer, and a third oxide layer that are sequentially stacked on the substrate.

9. The chip according to any one of claims 1 to 8, wherein the chip further comprises:
a metal layer, disposed on the surface that is of the mask structure and that is away from the substrate and/or the surface that is of the substrate and that is away from the mask structure, wherein
the conductive layer is electrically connected to the metal layer.

10. The chip according to any one of claims 1 to 9, wherein a material of the substrate comprises at least one of monocrystalline silicon, monocrystalline germanium, gallium arsenide, indium phosphide, an III-V compound semiconductor material, an II-VI compound semiconductor material, glass, plastic, or a sapphire wafer.

11. The chip according to any one of claims 1 to 10, wherein the mask structure comprises a titanium nitride layer, a silicon nitride layer, an aluminum oxide layer, or a silicon dioxide layer.

12. A chip preparation method, comprising:
forming a stack structure on a substrate;
forming a mask structure on the stack structure; and providing, on a surface that is of the mask structure and that is away from the substrate, a first via segment that penetrates the mask structure and the stack structure in a direction perpendicular to the substrate;
forming a first dielectric layer on a side wall of the first via segment, so that the first dielectric layer covers the side wall of the first via segment;
providing, on a bottom surface of the first via segment of which the first dielectric layer is formed on the side wall, a second via segment that penetrates the substrate in the direction perpendicular to the substrate, to provide, on the mask structure, a via that comprises the first via segment and the second via segment and that extends in the direction perpendicular to the substrate;
forming an insulation layer on the first dielectric layer and a side wall of the second via segment, so that the insulation layer covers the first dielectric layer and the second via segment, and encloses filling space in the via; and
forming a conductive layer in the filling space.

13. The chip preparation method according to claim 12, wherein the forming a first dielectric layer comprises:
forming the first dielectric layer on an inner wall surface of the first via segment, so that the first dielectric layer covers the inner wall surface of the first via segment; and
removing the first dielectric layer from the bottom surface of the first via segment.

14. The chip preparation method according to claim 12 or 13, wherein when the second via segment is formed, an edge of the first dielectric layer coincides with an edge of the second via segment at a location at which the first dielectric layer is connected to the second via segment.

15. The chip preparation method according to any one of claims 12 to 14, wherein after the forming an insulation layer and before the forming a conductive layer, the preparation method further comprises:
forming a diffusion barrier layer on the insulation layer;
forming an adhesion layer on the diffusion barrier layer; and
forming a seed layer on the adhesion layer; and
the forming a conductive layer comprises: forming the conductive layer in an area enclosed by the seed layer.

16. The chip preparation method according to any one of claims 12 to 15, wherein the forming a stack structure comprises:
sequentially stacking a plurality of layers in a multi-layer structure on the substrate.

17. The chip preparation method according to claim 16, wherein the forming a stack structure comprises:
sequentially stacking a first oxide layer, a silicon nitride layer, a second oxide layer, a dielectric material layer, and a third oxide layer on the substrate.

18. The chip preparation method according to any one of claims 12 to 17, wherein when the conductive layer is formed, the method comprises:
electroplating metal on an inner wall surface of the insulation layer to form the conductive layer.

19. The chip preparation method according to claim 13, wherein when the first via segment is formed and the first dielectric layer is removed from the bottom surface of the first via segment, a same etching cavity is used.

20. An electronic device, comprising:
a circuit board; and
the chip according to any one of claims 1 to 11, wherein the chip is disposed on the circuit board.
